# EUROPEAN PATENT APPLICATION

(11) **EP 4 199 045 A1**
(43) Date of publication of application: **21.06.2023**
(21) Application number: 22206711.8
(22) Date of filing: 10.11.2022
(51) Int. Cl.: H01L 21/48, H01L 23/498

(54) **FLEXIBLE LIQUID METAL CONNECTION DEVICE AND METHOD**

(30) Priority: 14.12.2021 US 202117550796
(71) Applicant: INTEL Corporation, Santa Clara, CA 95054 (US)
(72) Inventor: TADAYON, Pooya, Portland, 97225 (US); XU, Dingying, Chandler, 85248 (US); NEKKANTY, Srikant, Chandler, 85286 (US); MORET, Eric, Beaverton, 97007 (US); MURTAGIAN, Gregorio, Phoenix, 85045 (US); SMALLEY, Jeffory, East Olympia, 98540 (US); MEYYAPPAN, Karumbu, Portland, 97229 (US); LIN, Ziyin, Chandler, 85248 (US)
(74) Representative: HGF

(57) **Abstract**

An electronic device and associated methods are disclosed. In one example, the electronic device includes liquid metal pathways that form one or more conduction pathway through one or more dielectric layers. In selected examples, the dielectric layers are resilient, which allows for flexibility of interconnect components.

## Description

### Technical Field

Embodiments described herein generally relate electronic devices, such as semiconductor devices. Some specific embodiments described relate to interconnect interposer technologies.

### Background

Traditional multilayer substrates/interposers allow pitch scaling between levels. For example, a reduced first level interconnect pitch to an increased pitch in second level interconnect. However, they are rigid and face assembly related challenges during package assembly &/or surface mounting onto the board through second level interconnect. Thermal expansion coefficient difference between layers and materials is also a technical challenge. It is desired to have interconnect devices and methods that address these concerns, and other technical challenges.

### Brief Description of the Drawings

FIG. 1 shows an electronic device in accordance with some example embodiments.
FIG. 2 shows detail of a liquid metal interconnect in accordance with some example embodiments.
FIG. 3 shows detail of another liquid metal interconnect in accordance with some example embodiments.
FIG. 4 shows detail of another liquid metal interconnect in accordance with some example embodiments.
FIG. 5A shows selected operations of a method of forming a liquid metal interconnect in accordance with some example embodiments.
FIG. 5B shows selected operations of another method of forming a liquid metal interconnect in accordance with some example embodiments.
FIG. 5C shows selected operations of another method of forming a liquid metal interconnect in accordance with some example embodiments.
FIG. 6 shows detail of another liquid metal interconnect in accordance with some example embodiments.
FIG. 7 shows detail of another liquid metal interconnect in accordance with some example embodiments.
FIG. 8 shows a flow diagram of a method of manufacture of an electronic interconnect device in accordance with some example embodiments.
FIG. 9 shows a system that may incorporate an electronic interconnect device and methods, in accordance with some example embodiments.

### Description of Embodiments

The following description and the drawings sufficiently illustrate specific embodiments to enable those skilled in the art to practice them. Other embodiments may incorporate structural, logical, electrical, process, and other changes. Portions and features of some embodiments may be included in, or substituted for, those of other embodiments. Embodiments set forth in the claims encompass all available equivalents of those claims.

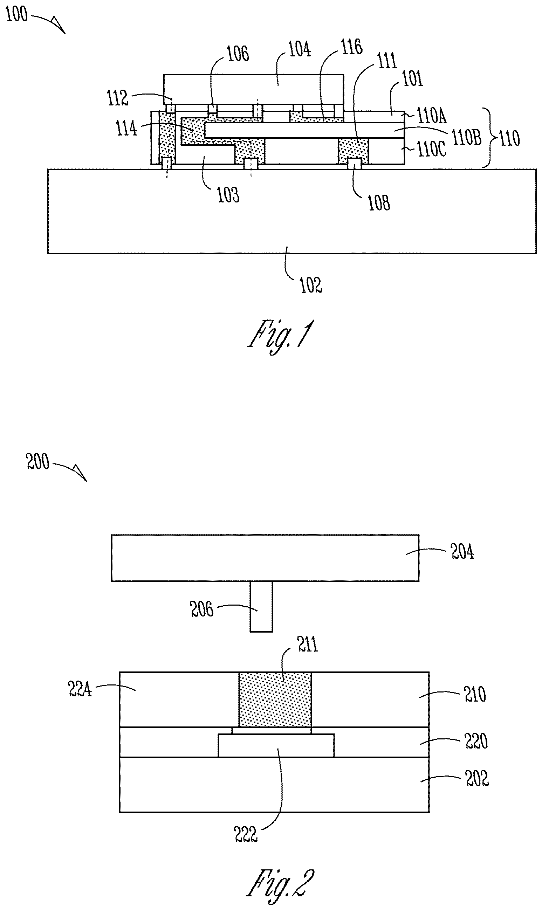

Figure 1 shows an electronic device 100. The electronic device 100 includes a semiconductor die 104 coupled to a substrate 102 through an interposing interconnect device 110. In the example of Figure 1, the interconnect device 110 includes a plurality of dielectric layers 110A, 110B, and 110C. Three dielectric layers are used as an example. The invention is not so limited. Other examples include two or more dielectric layers.

In one example, the plurality of dielectric layers 110A, 110B, 110C include compliant dielectric materials, to allow some degree of flexibility. Flexibility in the dielectric layers, in conjunction with flexibility of liquid metal as described below, allows for an interconnect device 110 to accommodate flexing and thermal expansion coefficient movement without cracking or breaking of electrical joints. In one example, the compliant material includes a polymer. In one example, the compliant material includes an elastomer. Examples of a polymers/elastomers include but are not limited to, polyimide, silicone, polyurethane, etc.

A liquid metal material 111 is shown within one or more of the plurality of dielectric layers 110A-C. In one example, the liquid metal includes gallium or a gallium alloy. Gallium and gallium alloys can be tailored by varying alloying elements and element amounts to be liquid at room temperature. Metals that are liquid at room temperature are useful because they easily form an electrical connection when a solid metal mating component penetrates the liquid metal. Example solid metal components include, but are not limited to, pins, rods, plates, or other geometries. Liquid metal is also flexible in geometry, while maintaining an electrical pathway through the liquid metal.

Figure 1 shows the liquid metal material traversing at least two layers of the plurality of dielectric layers 110A-C. In the example of Figure 1, the liquid metal forms a first conduction pathway 112 within the plurality of dielectric layers. The first conduction pathway 112 is shown as substantially vertical and passing through the plurality of dielectric layers 110A-C in a series of vias located one over another.

Figure 1 further shows a second conduction pathway 114 that traverses layers of the plurality of dielectric layers 110A-C in both vertical and horizontal directions. The first conduction pathway 112 and second conduction pathway 114 both pass through the plurality of dielectric layers 110A-C from a first major surface 101 to an opposite major surface 103.

A third pathway 116 is also shown. The third pathway 116 does not pass through from the first major surface 101 to the opposite major surface 103. In one example, the third pathway 116 only resides within one layer of the plurality of dielectric layers. In one example, the third pathway 116 passes through more than one of the plurality of dielectric layers.

Configurations that include a liquid metal material within one or more conduction pathways provide a number of advantages. One advantage includes physical flexibility of the interposing interconnect device 110. Bending of the interposing interconnect device 110 does not cause fractures of fatigue in conductors because the conductors are liquid. Another advantage includes ease of electrically connecting with adjacent devices such as the substrate 102 and the die 104. Metal contacts 106 and 108 are shown in Figure 1 that merely need to contact or penetrate the liquid metal 111 within one or more conduction pathways. Heating is not required, as with soldering techniques. Because heating is not required, connections require less time and devices are less susceptible to damage from differences in thermal expansion coefficients. Examples of metal contacts 106, 108 include, but are not limited to, pillars, plugs, pins, pads, etc. Although metal contacts 106, 108 are shown penetrating the liquid metal 111 in Figure 1, other examples include contacting at a flat interface.

In one example, the interposing interconnect device 110 includes a plurality of conduction pathways that change pitch between the first major surface 101, and the opposite major surface 103. Pitch scaling interposers may be used between devices or circuit boards, etc. with different electrical contact pitches to make the devices compatible with one another.

Figure 2 shows a close up view of an example electrical connection 200 similar to connections shown in Figure 1. A substrate 202 is shown and a device component 204 that is to be electrically connected to the substrate 202. One example of a device component 204 includes a surface of a die, as illustrated in Figure 1. Other device components 204 such as interposers are also within the scope of the invention. A first metal contact 206 and a second metal contact 222 are to be electrically connected through liquid metal 211. The liquid metal 211 is located within a conduction pathway within a dielectric layer 210. The liquid metal 211 is shown in contact with the second metal contact 222 on the substrate 202. In one example, an intermediate layer 224 is included between the second metal contact 222 and the liquid metal 211. In selected examples, the intermediate layer 224 is included as a passivation layer to reduce or prevent unwanted chemical interactions between the liquid metal and the second metal contact 222. In one example, the intermediate layer 224 is electrically conductive.

In the example shown, the first metal contact 206 is a pin. In one example, the pin is squared off at an end as illustrated. Other example configurations, include, but are not limited to, a sharpened tip. In the example shown, the second metal contact 222 is a pad. As illustrated, the second metal contact 222 provides a flat interface with the liquid metal 211 that provides electrical contact. Another example includes the first metal contact 206 as a pad and the second metal contact 222 as a pin. Another example includes the first metal contact 206 as a pad and the second metal contact 222 as a pad. Another example includes the first metal contact 206 as a pin and the second metal contact 222 as a pin. In one example, a mask layer 220 is included between the substrate 202 and the dielectric layer 210. The mask layer 220 may be used to form the pad 222 or the intermediate layer 224, or both. The mask layer 220 may also be used to form a flat interface between the substrate 202 and the dielectric layer 210.

In the example shown, the liquid metal 211 is contained within a cylinder shaped cavity within the dielectric layer 210. While a cylinder shaped geometry is used as an example, the invention is not so limited. Other examples include flat, rectangular, conical shaped, or other shaped cavities. Conical shaped cavities may help translate a larger contact on one side of dielectric layer or layers 210 to a smaller contact on an opposing side. Conical cavities may also result from a manufacturing process, such as laser drilling through dielectric layer or layers 210. In one example, the liquid metal 211 is contained within a hollow core of a metal plated via. Filling with liquid metal can be easier than additional core plating or other methods of filling a hollow core of a metal plated via. In one example, liquid metal filled plated through holes may be included in one or more layers of the interposing interconnect device 110 from Figure 1.

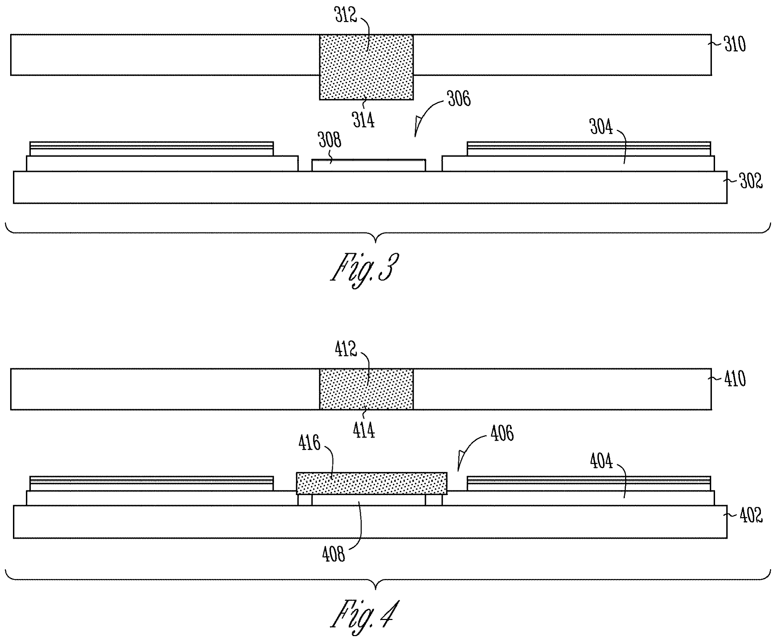

Figure 3 shows one method of forming an electrical connection using liquid metal according to an example. A dielectric layer 310 is shown. In one example, the dielectric layer 310 is part of a plurality of dielectric layers, such as in Figure 1. A liquid metal 312 is shown filling a cavity within the dielectric layer 310. An exposed end 314 of the liquid metal 312 is illustrated, ready to make an electrical connection with a metal contact 308, such as a connection pad. In the example of Figure 3, the exposed end of the liquid metal 312 includes excess liquid metal 312 protruding from the dielectric layer 310. Although the liquid metal 312 is liquid, surface tension will hold the liquid metal 312 in place within the cavity in the dielectric layer 310. Surface tension will also hold the excess liquid metal 312 in place until an electrical connection is formed as described below. Cavity dimensions and material choices for the dielectric layer 310 and liquid metal will determine an amount of surface tension in a given system. One of ordinary skill in the art, having the benefit of the present disclosure, will recognize a configuration necessary to provide sufficient surface tension.

The metal contact 308 is coupled to a substrate 302, similar to examples shown above. In one example a resist 304, such as a solder resist is located around the metal contact 308, and forms a containment region 306 around the metal contact 308. Although solder may, or may not be used, a solder resist is often used in manufacturing of electronic devices, and is a useful material to use in conjunction with liquid metal 312. Other materials to form a containment region 306 apart from solder resist are also within the scope of the invention.

In one method of attachment, when the dielectric layer 310 is brough into contact with the resist 304, the excess liquid metal 312 protruding from the dielectric layer 310 flows or presses out and fills the containment region 306. By using excess liquid metal 312, a more reliable electrical connection with the metal contact 308 is provided.

Figure 4 shows another method of forming an electrical connection using liquid metal according to an example. A dielectric layer 410 is shown. In one example, the dielectric layer 410 is part of a plurality of dielectric layers, such as in Figure 1. A liquid metal 412 is shown filling a cavity within the dielectric layer 410. An exposed end 414 of the liquid metal 412 is illustrated, ready to make an electrical connection with a metal contact 408, such as a connection pad.

The metal contact 408 is coupled to a substrate 402, similar to examples shown above. In one example a resist 404, such as a solder resist is located around the metal contact 408, and forms a containment region 406 around the metal contact 408. In the example of Figure 4, the metal contact 408 on the substrate 402 includes a mating amount of liquid metal 416.

In one method of attachment, when the dielectric layer 410 is brough into contact with the resist 404, the exposed end 414 of the liquid metal 412 contacts the mating amount of liquid metal 416 on the metal contact 408. Because the liquid metal 412 and the mating amount of liquid metal 416 are the same or similar materials, they have an affinity for each other, and will more easily form an electrical connection. In one example the containment region 406 is large enough to accommodate any excess liquid metal when the electrical connection is formed.

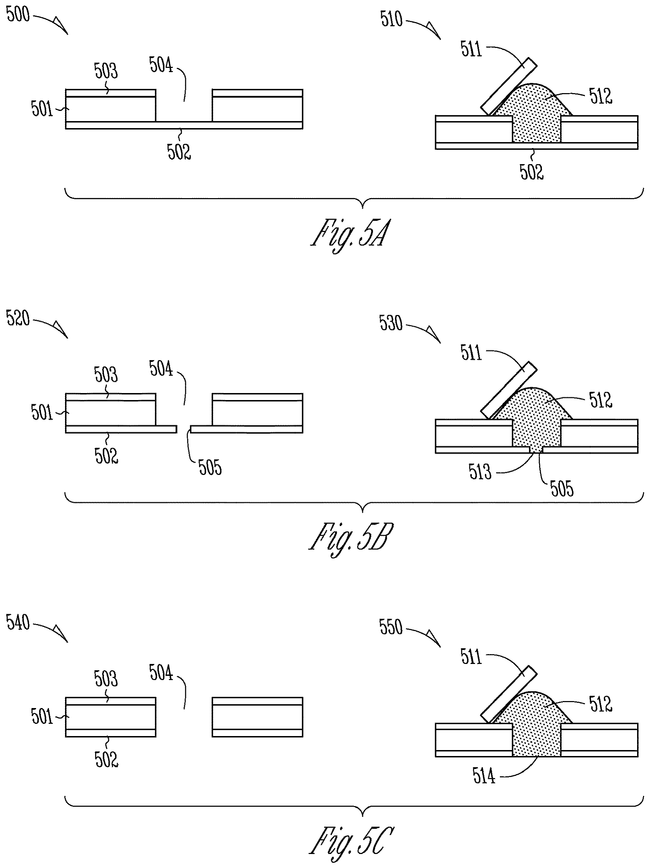

Figures 5A-5C show a number of examples of methods of forming an electronic interconnect device including liquid metal. In the method 500 Figure 5A, a patterned space 504 is formed in a dielectric layer 501. In one example, the patterned space 504 is formed by a subtractive technique, such as etching, drilling, or otherwise removing material from a sheet of dielectric to form the space 504. In one example, the patterned space 504 is formed by molding a dielectric material around a form, for example injection molding the dielectric material with a pattern of spaces 504.

A bottom cap layer 502 and a top cap layer 503 are shown in Figure 5A. In selected examples, one or more cap layers 502, 503 may be used to at least partially contain liquid metal during a filling operation. In Figure 5A, a blade 511 such as a squeegee blade is drawn across the dielectric layer 501 and forces an excess of liquid metal 512 into the patterned space 504. In the example of Figure 5A, the bottom cap layer 502 is continuous, and contains the liquid metal 512 from below.

Figure 5B shows another example method 520 of forming an electronic interconnect device including liquid metal. Similar to Figure 5A, in Figure 5B, a patterned space 504 is formed in a dielectric layer 501. A bottom cap layer 502 and a top cap layer 503 are shown in Figure 5B. In the example of Figure 5B, a vent hole 505 is included in the bottom cap layer 502. As the blade 511 is drawn across the patterned space 504, the vent hole 505 allows removal of excess liquid metal 512 from the patterned space 504.

Figure 5C shows another example method 540 of forming an electronic interconnect device including liquid metal. Similar to Figures 5A, and 5B, in Figure 5C, a patterned space 504 is formed in a dielectric layer 501. A bottom cap layer 502 and a top cap layer 503 may be included as shown. In the example of Figure 5C, a back side of the patterned space 504 is left completely open, and allows for removal of excess liquid metal 512 from the patterned space 504. As noted above, given proper material choice, and dimensional choice, surface tension will hold the liquid metal 512 in the patterned space 504 when the back side of the patterned space 504 is left completely open.

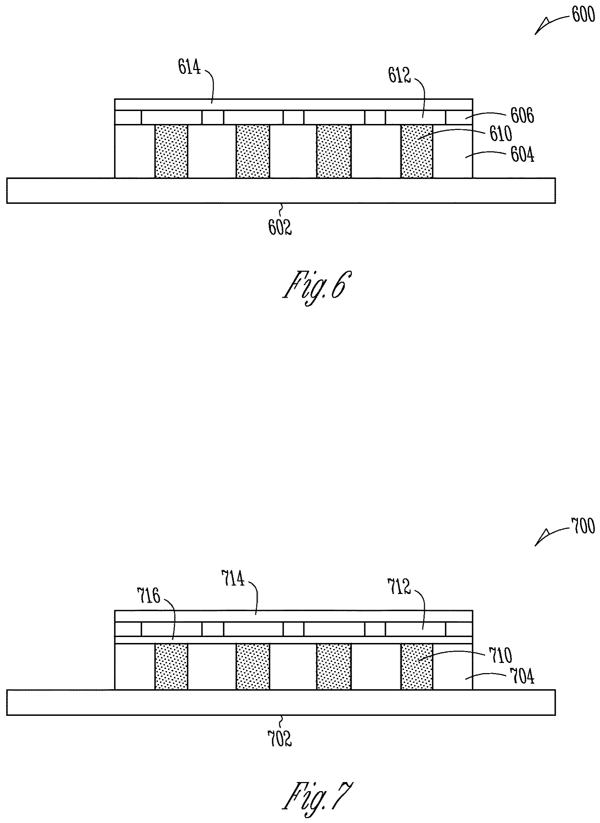

Figure 6 shows an example of an electronic interconnect device 600 including liquid metal. In Figure 6, a dielectric layer 604 is shown, including a number of liquid metal filled vias 610. A number of air gaps 612 are shown above the number of liquid metal filled vias 610. In one example the air gaps 612 provide a dielectric function to ensure that excess liquid metal at a top of a filled via 610 does not cause a short, or unwanted electrical interference between adjacent filled vias 610. In the example of Figure 6, a sealing layer 614 is further included to contain the liquid metal in the filled vias 610.

In one example, the air gaps 612 are wider than the filled vias 610. One method of forming a wider air gap 612 includes forming more than one dielectric layer laminated together. In the example of Figure 6, the dielectric layer 604 containing the filled vias 610 may be laminated to a subsequent dielectric layer 606 containing the air gaps 612.

Figure 7 shows another example of an electronic interconnect device 700 including liquid metal. Similar to Figure 6, in Figure 7, a dielectric layer 704 is shown, including a number of liquid metal filled vias 710. A number of air gaps 712 are shown above the number of liquid metal filled vias 710. In Figure 7, a capping layer 716 is further shown between the liquid metal filled vias 710 and the air gaps 712. In the example of Figure 7, a sealing layer 714 is further included to define and maintain the air gaps 712 between the capping layer 716 and the sealing layer 714.

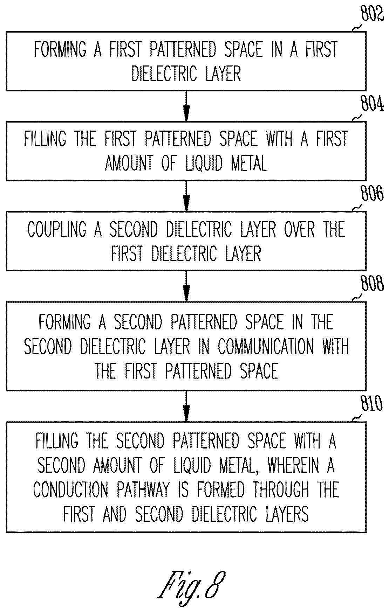

Figure 8 shows an example method of forming an electronic interconnect device. In operation 802, a first patterned space is formed in a first dielectric layer. In operation 804, the first patterned space is filled with a first amount of liquid metal. In operation 806, a second dielectric layer is coupled over the first dielectric layer. In operation 808, a second patterned space is formed in the second dielectric layer in communication with the first patterned space. In operation 810, the second patterned space is filled with a second amount of liquid metal, wherein a conduction pathway is formed through the first and second dielectric layers.

In one example, coupling between dielectric layers is accomplished using one or more adhesive layers between dielectric layers. Other methods of coupling between dielectric layers include, but are not limited to, chemical attachment, thermal attachment, mechanical attachment etc. Alignment between layers may be accomplished using optical fiducial features, or by electrical detection of alignment through one or more conduction pathways thought the dielectric layers. Layers may be filled with liquid metal after lamination, or pre-filled layers may be laminated, using surface tension and/or viscosity of liquid metal to hold liquid metal in the spaces during lamination.

In one example, the method of Figure 8 is used to form multi-layered interconnect devices such as the interposer 110 of Figure 1, or layers of other devices described in examples above.

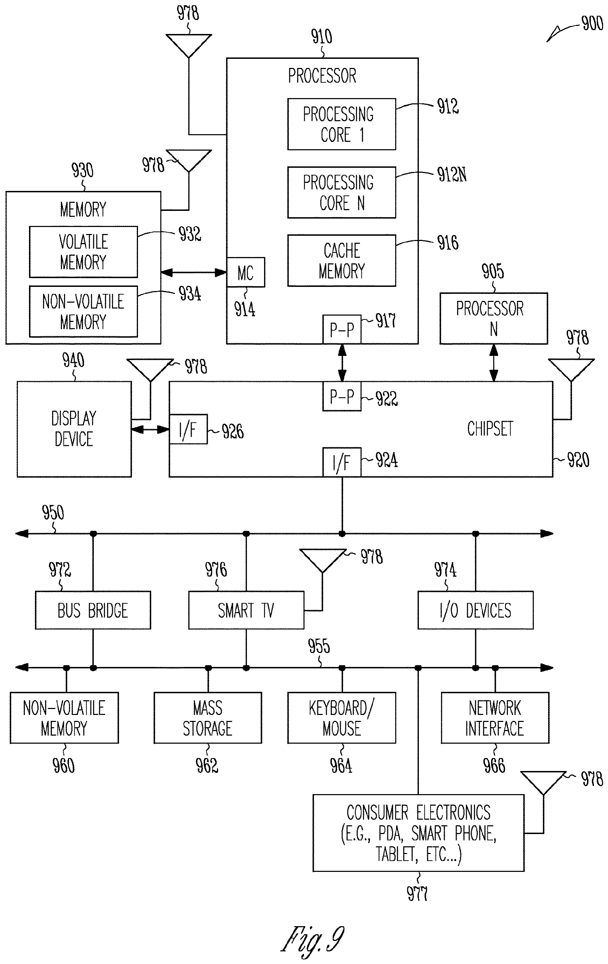

Figure 9 illustrates a system level diagram, depicting an example of an electronic device (e.g., system) that may include an electronic interconnect device with liquid metal and/or methods described above. In one embodiment, system 900 includes, but is not limited to, a desktop computer, a laptop computer, a netbook, a tablet, a notebook computer, a personal digital assistant (PDA), a server, a workstation, a cellular telephone, a mobile computing device, a smart phone, an Internet appliance or any other type of computing device. In some embodiments, system 900 includes a system on a chip (SOC) system.

In one embodiment, processor 910 has one or more processor cores 912 and 912N, where 912N represents the Nth processor core inside processor 910 where N is a positive integer. In one embodiment, system 900 includes multiple processors including 910 and 905, where processor 905 has logic similar or identical to the logic of processor 910. In some embodiments, processing core 912 includes, but is not limited to, pre-fetch logic to fetch instructions, decode logic to decode the instructions, execution logic to execute instructions and the like. In some embodiments, processor 910 has a cache memory 916 to cache instructions and/or data for system 900. Cache memory 916 may be organized into a hierarchal structure including one or more levels of cache memory.

In some embodiments, processor 910 includes a memory controller 914, which is operable to perform functions that enable the processor 910 to access and communicate with memory 930 that includes a volatile memory 932 and/or a non-volatile memory 934. In some embodiments, processor 910 is coupled with memory 930 and chipset 920. Processor 910 may also be coupled to a wireless antenna 978 to communicate with any device configured to transmit and/or receive wireless signals. In one embodiment, an interface for wireless antenna 978 operates in accordance with, but is not limited to, the IEEE 802.11 standard and its related family, Home Plug AV (HPAV), Ultra Wide Band (UWB), Bluetooth, WiMax, or any form of wireless communication protocol.

In some embodiments, volatile memory 932 includes, but is not limited to, Synchronous Dynamic Random Access Memory (SDRAM), Dynamic Random Access Memory (DRAM), RAMBUS Dynamic Random Access Memory (RDRAM), and/or any other type of random access memory device. Non-volatile memory 934 includes, but is not limited to, flash memory, phase change memory (PCM), read-only memory (ROM), electrically erasable programmable read-only memory (EEPROM), or any other type of non-volatile memory device.

Memory 930 stores information and instructions to be executed by processor 910. In one embodiment, memory 930 may also store temporary variables or other intermediate information while processor 910 is executing instructions. In the illustrated embodiment, chipset 920 connects with processor 910 via Point-to-Point (PtP or P-P) interfaces 917 and 922. Chipset 920 enables processor 910 to connect to other elements in system 900. In some embodiments of the example system, interfaces 917 and 922 operate in accordance with a PtP communication protocol such as the Intel^{®} QuickPath Interconnect (QPI) or the like. In other embodiments, a different interconnect may be used.

In some embodiments, chipset 920 is operable to communicate with processor 910, 905N, display device 940, and other devices, including a bus bridge 972, a smart TV 976, I/O devices 974, nonvolatile memory 960, a storage medium (such as one or more mass storage devices ) 962, a keyboard/mouse 964, a network interface 966, and various forms of consumer electronics 977 (such as a PDA, smart phone, tablet etc.), etc. In one embodiment, chipset 920 couples with these devices through an interface 924. Chipset 920 may also be coupled to a wireless antenna 978 to communicate with any device configured to transmit and/or receive wireless signals. In one example, any combination of components in a chipset may be separated by a continuous flexible shield as described in the present disclosure.

Chipset 920 connects to display device 940 via interface 926. Display 940 may be, for example, a liquid crystal display (LCD), a light emitting diode (LED) array, an organic light emitting diode (OLED) array, or any other form of visual display device. In some embodiments of the example system, processor 910 and chipset 920 are merged into a single SOC. In addition, chipset 920 connects to one or more buses 950 and 955 that interconnect various system elements, such as I/O devices 974, nonvolatile memory 960, storage medium 962, a keyboard/mouse 964, and network interface 966. Buses 950 and 955 may be interconnected together via a bus bridge 972.

In one embodiment, mass storage device 962 includes, but is not limited to, a solid state drive, a hard disk drive, a universal serial bus flash memory drive, or any other form of computer data storage medium. In one embodiment, network interface 966 is implemented by any type of well-known network interface standard including, but not limited to, an Ethernet interface, a universal serial bus (USB) interface, a Peripheral Component Interconnect (PCI) Express interface, a wireless interface and/or any other suitable type of interface. In one embodiment, the wireless interface operates in accordance with, but is not limited to, the IEEE 802.11 standard and its related family, Home Plug AV (HPAV), Ultra Wide Band (UWB), Bluetooth, WiMax, or any form of wireless communication protocol.

While the modules shown in FIG. 9 are depicted as separate blocks within the system 900, the functions performed by some of these blocks may be integrated within a single semiconductor circuit or may be implemented using two or more separate integrated circuits. For example, although cache memory 916 is depicted as a separate block within processor 910, cache memory 916 (or selected aspects of 916) can be incorporated into processor core 912.

To better illustrate the method and apparatuses disclosed herein, a non-limiting list of embodiments is provided here:
Example 1 includes an electronic interconnect device. The electronic interconnect device includes a plurality of dielectric layers, at least one conduction pathway within the plurality of dielectric layers, and a liquid metal material within the conduction pathway, wherein the liquid metal material traverses at least two layers of the plurality of dielectric layers.
Example 2 includes the electronic interconnect device of example 1, wherein the conduction pathway traverses from a major surface of the interconnect device to an opposite major surface.
Example 3 includes the electronic interconnect device of any one of examples 1-2, wherein the liquid metal includes gallium.
Example 4 includes the electronic interconnect device of any one of examples 1-3, wherein the liquid metal includes gallium and indium.
Example 5 includes the electronic interconnect device of any one of examples 1-4, wherein the plurality of dielectric layers includes elastomer layers.
Example 6 includes the electronic interconnect device of any one of examples 1-5, wherein the conduction pathway traverses layers of the plurality of dielectric layers in both vertical and horizontal directions.
Example 7 includes the electronic interconnect device of any one of examples 1-6, wherein the conduction pathway includes a plated through hole via filled with liquid metal in at least one layer.
Example 8 includes the electronic interconnect device of any one of examples 1-7, further including at least one liquid metal filled via with an air gap above the liquid metal filled via.
Example 9 includes the electronic interconnect device of any one of examples 1-8, further including a capping layer between the liquid metal filled via and the air gap.
Example 10 includes an electronic device. The electronic device include a semiconductor die coupled to a substrate through an interposing interconnect device. The interposing interconnect device includes a plurality of dielectric layers, at least one conduction pathway within the plurality of dielectric layers, and a liquid metal material within the conduction pathway, wherein the liquid metal material traverses at least two layers of the plurality of dielectric layers.
Example 11 includes the electronic device of example 10, wherein the interconnect device includes a first major surface, and an opposite major surface, and wherein the at least one conduction pathway includes a plurality of conduction pathways that change pitch between the first major surface, and the opposite major surface.
Example 12 includes the electronic device of any one of examples 10-11, wherein the plurality of dielectric layers includes elastomer layers.
Example 13 includes the electronic device of any one of examples 10-12, wherein the conduction pathway includes vertical vias and horizontal traces.
Example 14 includes the electronic device of any one of examples 10-13, wherein the vertical via includes a cylinder geometry.
Example 15 includes the electronic device of any one of examples 10-14, wherein the vertical via includes a conical geometry.
Example 16 includes the electronic device of any one of examples 10-15, wherein the plurality of dielectric layers includes different materials in different layers.
Example 17 includes a method of forming an electronic interconnect device. The method includes forming a first patterned space in a first dielectric layer, filling the first patterned space with a first amount of liquid metal, coupling a second dielectric layer over the first dielectric layer, forming a second patterned space in the second dielectric layer in communication with the first patterned space, and filling the second patterned space with a second amount of liquid metal, wherein a conduction pathway is formed through the first and second dielectric layers.
Example 18 includes the method of example 17, wherein forming the first patterned space in the first dielectric layer includes injection molding a patterned first dielectric layer.
Example 19 includes the method of any one of examples 17-18, wherein filling the first patterned space includes screen printing the first amount of liquid metal.
Example 20 includes the method of any one of examples 17-19, further including removing excess liquid metal in the first patterned space through a vent hole.
Example 21 includes the method of any one of examples 17-20, wherein coupling the second dielectric layer includes coupling with an adhesive layer.
Example 22 includes the method of any one of examples 17-21, further including coupling the interconnect to a substrate, wherein an exposed end of the first patterned space includes excess liquid metal protruding from the first patterned space.
Example 23 includes the method of any one of examples 17-22, further including coupling an exposed end of the first patterned space to a pad on a substrate, wherein the pad on the substrate includes a mating amount of liquid metal.

Throughout this specification, plural instances may implement components, operations, or structures described as a single instance. Although individual operations of one or more methods are illustrated and described as separate operations, one or more of the individual operations may be performed concurrently, and nothing requires that the operations be performed in the order illustrated. Structures and functionality presented as separate components in example configurations may be implemented as a combined structure or component. Similarly, structures and functionality presented as a single component may be implemented as separate components. These and other variations, modifications, additions, and improvements fall within the scope of the subject matter herein.

Although an overview of the inventive subject matter has been described with reference to specific example embodiments, various modifications and changes may be made to these embodiments without departing from the broader scope of embodiments of the present disclosure. Such embodiments of the inventive subject matter may be referred to herein, individually or collectively, by the term "invention" merely for convenience and without intending to voluntarily limit the scope of this application to any single disclosure or inventive concept if more than one is, in fact, disclosed.

The embodiments illustrated herein are described in sufficient detail to enable those skilled in the art to practice the teachings disclosed. Other embodiments may be used and derived therefrom, such that structural and logical substitutions and changes may be made without departing from the scope of this disclosure. The Detailed Description, therefore, is not to be taken in a limiting sense, and the scope of various embodiments is defined only by the appended claims, along with the full range of equivalents to which such claims are entitled.

As used herein, the term "or" may be construed in either an inclusive or exclusive sense. Moreover, plural instances may be provided for resources, operations, or structures described herein as a single instance. Additionally, boundaries between various resources, operations, modules, engines, and data stores are somewhat arbitrary, and particular operations are illustrated in a context of specific illustrative configurations. Other allocations of functionality are envisioned and may fall within a scope of various embodiments of the present disclosure. In general, structures and functionality presented as separate resources in the example configurations may be implemented as a combined structure or resource. Similarly, structures and functionality presented as a single resource may be implemented as separate resources. These and other variations, modifications, additions, and improvements fall within a scope of embodiments of the present disclosure as represented by the appended claims. The specification and drawings are, accordingly, to be regarded in an illustrative rather than a restrictive sense.

The foregoing description, for the purpose of explanation, has been described with reference to specific example embodiments. However, the illustrative discussions above are not intended to be exhaustive or to limit the possible example embodiments to the precise forms disclosed. Many modifications and variations are possible in view of the above teachings. The example embodiments were chosen and described in order to best explain the principles involved and their practical applications, to thereby enable others skilled in the art to best utilize the various example embodiments with various modifications as are suited to the particular use contemplated.

It will also be understood that, although the terms "first," "second," and so forth may be used herein to describe various elements, these elements should not be limited by these terms. These terms are only used to distinguish one element from another. For example, a first contact could be termed a second contact, and, similarly, a second contact could be termed a first contact, without departing from the scope of the present example embodiments. The first contact and the second contact are both contacts, but they are not the same contact.

The terminology used in the description of the example embodiments herein is for the purpose of describing particular example embodiments only and is not intended to be limiting. As used in the description of the example embodiments and the appended examples, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

As used herein, the term "if' may be construed to mean "when" or "upon" or "in response to determining" or "in response to detecting," depending on the context. Similarly, the phrase "if it is determined" or "if [a stated condition or event] is detected" may be construed to mean "upon determining" or "in response to determining" or "upon detecting [the stated condition or event]" or "in response to detecting [the stated condition or event]," depending on the context.

## Claims

1. An electronic device, comprising:
a semiconductor die coupled to a substrate through an interposing interconnect device, the interposing interconnect device including;
a plurality of dielectric layers;
at least one conduction pathway within the plurality of dielectric layers; and
a liquid metal means within the conduction pathway, wherein the liquid metal means traverses at least two layers of the plurality of dielectric layers.

2. The electronic device of claim 1, wherein the interconnect device includes a first major surface, and an opposite major surface, and wherein the at least one conduction pathway includes a plurality of conduction pathways that change pitch between the first major surface, and the opposite major surface.

3. The electronic device of any one of the preceding claims, wherein the plurality of dielectric layers includes elastomer layers.

4. The electronic device of any one of the preceding claims, wherein the conduction pathway includes vertical vias and horizontal traces.

5. The electronic device of any one of the preceding claims, wherein the vertical via includes a cylinder geometry.

6. The electronic device of any one of the preceding claims, wherein the vertical via includes a conical geometry.

7. The electronic device of any one of the preceding claims, wherein the plurality of dielectric layers includes different materials in different layers.

8. A method of forming an electronic interconnect device, comprising:
forming a first patterned space in a first dielectric layer;
filling the first patterned space with a first amount of liquid metal;
coupling a second dielectric layer over the first dielectric layer;
forming a second patterned space in the second dielectric layer in communication with the first patterned space; and
filling the second patterned space with a second amount of liquid metal, wherein a conduction pathway is formed through the first and second dielectric layers.

9. The method of claim 8, wherein forming the first patterned space in the first dielectric layer includes injection molding a patterned first dielectric layer.

10. The method of claim 8, wherein filling the first patterned space includes screen printing the first amount of liquid metal.

11. The method of claim 10, further including removing excess liquid metal in the first patterned space through a vent hole.

12. The method of claim 8, wherein coupling the second dielectric layer includes coupling with an adhesive layer.

13. The method of claim 8, further including coupling the interconnect to a substrate, wherein an exposed end of the first patterned space includes excess liquid metal protruding from the first patterned space.

14. The method of claim 8, further including coupling an exposed end of the first patterned space to a pad on a substrate, wherein the pad on the substrate includes a mating amount of liquid metal.
